# EUROPEAN PATENT APPLICATION

(11) **EP 3 244 496 A1**
(43) Date of publication of application: **15.11.2017**
(21) Application number: 17170454.7
(22) Date of filing: 10.05.2017
(51) Int. Cl.: H01S 5/028

(54) **METHOD FOR OBTAINING A LASER DIODE**

(30) Priority: 11.05.2016 IT UA20163362
(71) Applicant: Prima Electro S.p.A., 10024 Moncalieri (TO) (IT)
(72) Inventor: ROGGERO, Guido, 10073 Ciriè TORINO (IT); MENEGHINI, Giancarlo, 10141 TORINO (TO) (IT); MORELLO, Giuliana, 10141 TORINO (TO) (IT); STANO, Alessandro, 10077 S. Maurizio C.se (TO) (IT); ROSSO, Marzia, 10198 RIVOLI (TO) (IT)
(74) Representative: Camolese, Marco

(57) **Abstract**

Method for obtaining a laser diode (1) with vertical mirrors, comprising the steps of:
- providing (100) a substrate (2) comprising optical layers (4, 6, 8);
- performing (102) a first dry etching of said substrate (2), so as to get two opposite transversal facets (10) having a predetermined depth, which represent the lateral walls of a cavity (12);
- cleaning (104) the bottom of said cavity (12);
- depositing (106) a coating layer (52) on the whole substrate (2);
- performing (108) a second etching, so as to free the bottom of the cavity (12) from the coating layer (52);
- performing (110) a third deep etching of the bottom of the cavity (12);
- removing (112) the coating layer (52), so as to obtain said diode (1) with transversal mirrors (10).

## Description

The present invention relates to a method for obtaining a laser diode.

A laser diode is a semiconductor diode, the active material of which, consisting of a p-i-n heterojunction, allows obtaining optical gain within a wavelength range determined by the epitaxial structure of alloys of semiconductor materials it is composed of, and such heterojunction (optical medium) is inserted in a cavity that is resonant for the optical field. The population inversion necessary for the laser emission is obtained by means of a current injection into the junction itself. The terminal faces on a laser diode (chip) are used for forming the resonant cavity (called laser cavity); an external mirror and/or a Bragg reflector may also be used for this purpose.

Traditionally, therefore, feedback occurs through the mirrors of the semiconductor laser, which are produced by cleavage of the crystal along crystallographic planes with a weak chemical bond.

The mirrors are essential for laser operation and must have well-controlled optical reflectivity values. Lasers fabricated in this manner are not functional until after optical coatings have been applied onto the bars (and therefore onto the cleaved facets) obtained from the wafer. This implies that a large number of bars must be obtained starting from a complete wafer having a diameter in the range of 2 to 6 inches, which bars must then be handled individually for depositing the (anti-reflective and high-reflectivity) optical layers on the mirrors. Moreover, diode testing is complex as well, because of the necessity of verifying the operating conditions of the devices on the single bars.

This is a delicate process that requires much time and labour, since it is necessary to avoid damaging the lasers and the mirrors while handling them.

The handling and testing of devices at bar level is a significant factor in the cost of edge-emitting lasers with cleaved facets.

It is therefore one object of the present invention to propose a method for obtaining a laser diode wherein it is no longer necessary to handle the bars individually and wherein the operations required for testing the diode on the whole wafer are simplified.

These and other objects are achieved through a method for obtaining a laser diode having the features set out in claim 1.

Particular embodiments of the invention are set out in dependent claims, the contents of which should be understood as being an integral part of the present description.

Further features and advantages of the invention will be illustrated in the following detailed description, which is provided merely by way of non-limiting example with reference to the annexed drawings, wherein:
- Figure 1 is a sectional view of a laser-diode device fabricated in accordance with the method of the present invention;
- Figures 2 to 5 are sectional views showing a number of progressive steps of the method according to the present invention; and
- Figure 6 is a block diagram of the steps of the method according to the present invention. In brief, the method according to the present invention is based on the idea of fabricating the mirrors by vertical etching and applying the optical coatings at wafer level after etching.

In this manner, the lasers become fully functional at whole wafer level, and this allows for low-cost wafer probing of the devices for measuring the laser's operating parameters, such as threshold currents/voltages, series resistance, lifetime versus current and voltage, emission wavelength and emission spectrum.

Producing facets through a wafer etching process increases the number of fabrication steps, but greatly reduces the amount of bar-level handling, resulting in overall yield improvements and reduced production time and cost.

The new technique for fabricating laser mirrors, hereafter referred to as Double-Etch Mixed (facet) Etching Solution (DE-MES), allows overcoming the limitations of cleaved lasers. According to the method of the present invention, laser mirrors are no longer obtained by cleavage at the end of the wafer fabrication process, but are formed on the whole wafer during the wafer fabrication process.

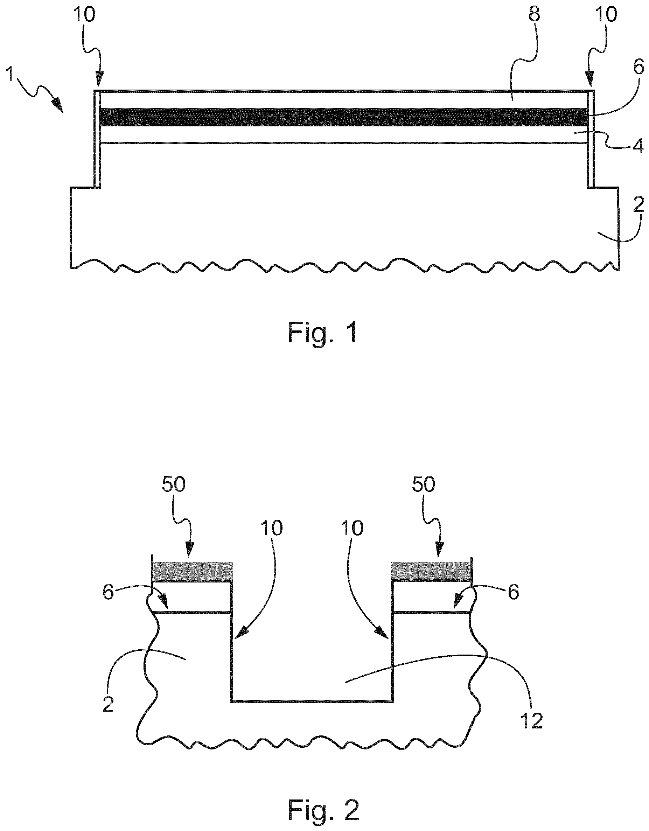

Figure 1 shows a sectional view of a laser diode 1 made in accordance with the method of the present invention, which comprises, from bottom to top, a substrate 2, a first confinement layer 4, an active layer 6 (a quantum-well structure for optical gain at a predetermined wavelength), and a second confinement layer 8, said semiconductor layers being limited, at two opposite ends of the diode 1, by two mirrors 10 that define an optical cavity.

The confinement layers, grown by epitaxy on the semiconductor substrate 2 and incorporating the quantum-well layer 6 responsible for the proper formation of the heterojunction, allow for effective injection of current into the active layer 6 and ensure optical confinement.

The steps of the method according to the present invention will now be described with reference to Figures 2 to 5.

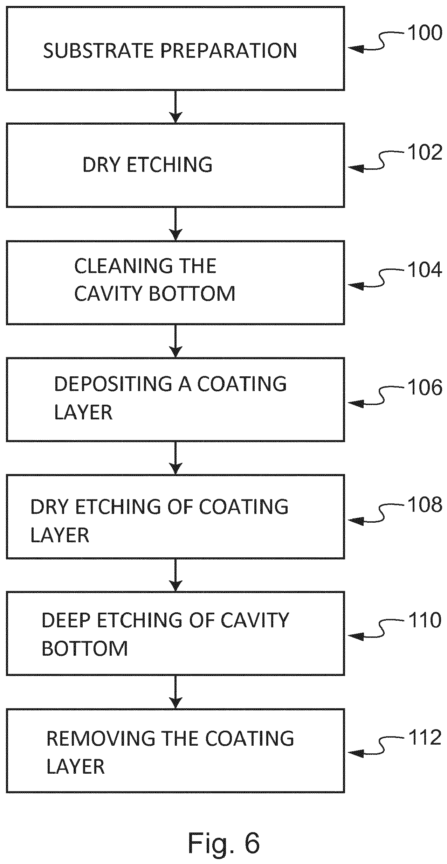

Figure 6 shows a block diagram of said steps.

In a first step 100, the epitaxial structure comprising the substrate 2 and the layers 4, 6 and 8 (epitaxial wafer) to be treated is prepared, and in a step 102 a first dry etching is performed on the epitaxial wafer by using a dry etching technique (e.g. Reactive Ion Etching - RIE, or Inductively Coupled Plasma - ICP), so as to obtain two mirrors 10 (two transversal facets opposite to each other, which will then be coated to create respective mirrors with controlled reflectivity), etched to a predetermined depth, e.g. 3-4 µm. Such facets represent, when the etching 102 is complete, the lateral walls of a cavity 12.

This step is carried out by depositing on the epitaxial wafer a first layer of coating material 50, preferably a dielectric one, such as, for example, silicon oxide (SiO₂) or silicon nitride (SiN) deposited from gaseous phase, which has a predetermined thickness, e.g. approximately 1-2 µm.

A lithography is effected on the layer of dielectric material 50 in order to obtain a mask for protecting the areas that must not be etched, and, during the etching step 102, a first etching is performed on the dielectric layer 50, followed by a second etching of the epitaxial wafer for forming the transversal facets (thus creating the cavity 12).

Figure 2 shows a schematic sectional view of the diode of Figure 1, wherein the active layer 6 is represented as a simple line for graphic convenience, and wherein the two vertical walls represent two transversal facets (which will become the two high- and low-reflectivity mirrors 10 thanks to the presence, on said facets, of the optical layers, as previously described) of two contiguous laser diodes.

The cavity 12 represents a zone of separation between two contiguous laser diodes (a plurality of diodes 1 are formed on the starting epitaxial wafer, which at the end of the process will have to be separated one by one). At the end of the method according to the present invention, the epitaxial wafer is cleaved in order to 'free' the mirrors 10 of the various diodes 1.

The transversal facets are made by carrying out a dry etching process, and preferably have a vertical profile of 90° ± 2°, with a predetermined surface roughness, preferably lower than 20nm RMS.

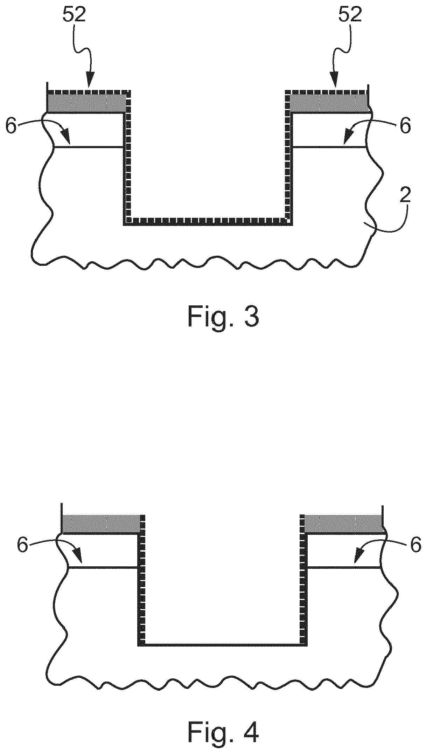

During the next step 104, the bottom of the cavity 12 is cleaned, and then, at step 106, a second coating layer 52, preferably a dielectric layer similar to the first coating layer 50, is deposited, which has a predetermined thickness, e.g. 0.5µm (see Figure 3).

In a step 108, a subsequent dry etching is performed on this dielectric layer 52, so as to free the bottom of the cavity from the dielectric material 52 (see Figure 4).

Due to the directionality that characterizes this etching 108, it is possible to avoid removing the dielectric layer 52 deposited on the previously formed mirror 10, thus protecting it.

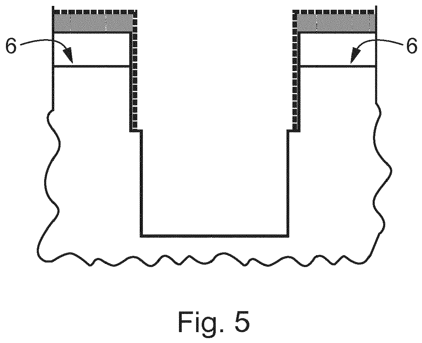

At this point, in step 110, a deep etching is performed on the bottom of the cavity 12 by etching in corrosive solution or, as an alternative, by reactive plasma etching (see Figure 5). This further etching 110 of the semiconductor, whether wet or dry, is useful for eliminating any reflections on the bottom of the cavity, produced by the light beam emitted by the mirror 10.

With this method, the most sensitive area of the mirror 10 is protected and preserved by the second dielectric layer 52.

Total depth may be in the range of a few micrometers (10-15µm).

When this etching 110 is complete, the masking dielectric layers 50, 52 are both removed 112.

The above-described method for obtaining a laser diode fabricates the mirrors of the laser 10 by direct etching on the wafer, resulting in time and labour savings and increased yield.

After the mirrors 10 have been fabricated, the mirrors 10 are subjected to passivation through deposition of dielectric layers by means of *per se* known evaporation or CVD techniques. Finally, a plurality of metallic layers are deposited on the wafer by using a sputtering and/or evaporation technique, which produce, in a *per se* known manner, an ohmic contact for the diode 1.

The dielectric layers act as a real antireflection coating, i.e. they reduce the residual reflectivity obtained from the semiconductors/air interface.

The main features of the method of the present invention are:
- the use of the etched facets technology results, due to the fact that the mirror 10 of the optical cavity can be formed without using the conventional wafer cleavage technique, in a considerably shorter processing time, wafer-scale device testing and improved process yield;
- facet fabrication in two successive steps results in a mirror area (Figure 2) having superior morphological characteristics;
- the first masking effected by means of the dielectric layer 50 (Figure 2) can be obtained more easily than required by deep etching;
- the laser mirror 10, obtained after the first etching 102, is immediately protected by depositing the second dielectric layer 52 (Figure 3), thereby eliminating the risk of damage;
- the use of two separate process steps allows the use of less expensive and delicate equipment (Reactive Ion Etching) than required for a single deep etching (Inductively Coupled Plasma).

Of course, without prejudice to the principle of the invention, the forms of embodiment and the implementation details may be extensively varied from those described and illustrated herein by way of non-limiting example, without however departing from the protection scope of the present invention as set out in the appended claims.

## Claims

1. Method for obtaining a laser diode (1), comprising the steps of:
- providing (100) a substrate (2) comprising optical layers (4, 6, 8);
- performing (102) a first dry etching of said substrate (2), so as to obtain two opposite transversal facets (10) having a predetermined depth, which represent the lateral walls of a cavity (12);
- cleaning (104) the bottom of said cavity (12);
- depositing (106) a coating layer (52) on the whole substrate (2);
- performing (108) a second etching, so as to free the bottom of the cavity (12) from the coating layer (52);
- performing (110) a third deep etching of the bottom of the cavity (12);
- removing (112) the coating layer (52), so as to obtain said laser diode (1), wherein said transversal facets are the transversal mirrors (10) of the diode (1).

2. Method according to claim 1, wherein the first etching (102) comprises the steps of:
- depositing a coating layer (50) on the substrate (2);
- performing a lithography, so as to obtain a predetermined mask;
- performing a first etching of the dielectric layer;
- performing a second etching to obtain the cavity (12).

3. Method according to claim 1 or 2, wherein the transversal facets have a vertical profile of 90° ± 2°, with a predetermined surface roughness.

4. Method according to claim 1, wherein the deep etching of the bottom of the cavity (12) is performed through corrosive solution or reactive plasma etching.

5. Method according to claim 1, wherein the coating layer is silicon oxide or silicon nitride deposited from gaseous phase.

6. Method according to claim 1, further comprising the steps of:
- performing a passivation of the mirrors (10) through deposition of dielectric layers;
- depositing a plurality of metallic layers on the diode (1) in order to obtain an ohmic contact for the diode (1).
